# EUROPÄISCHE PATENTSCHRIFT

(11) **EP 1 656 706 B1**
(45) Veröffentlichungstag und Bekanntmachung des Hinweises auf die Patenterteilung: **18.07.2018**
(21) Anmeldenummer: 04741150.9
(22) Anmeldetag: 20.07.2004
(51) Int. Cl.: H01L 51/50

(54) **ORGANISCHES ELEKTROLUMINESZENZELEMENT**
ORGANIC ELECTROLUMINESCENT ELEMENT
ELEMENT ELECTROLUMINESCENT ORGANIQUE

(30) Priorität: 21.07.2003 DE 10333232
(43) Veröffentlichungstag der Anmeldung: 17.05.2006
(73) Patentinhaber: Merck Patent GmbH, 64293 Darmstadt (DE)
(72) Erfinder: GERHARD, Anja, 64291 Darmstadt (DE); STÖSSEL, Philipp, 60487 Frankfurt am Main (DE); VESTWEBER, Horst, 34830 Gilserberg-Winterscheid (DE)
(86) Internationale Anmeldenummer: PCT/EP2004/008070
(87) Internationale Veröffentlichungsnummer: WO 2005/011013

(56) Entgegenhaltungen:
- EP-A- 1 154 498
- WO-A-01/29909
- WO-A-99/26730
- WO-A-02/074015
- US-A- 6 166 489
- US-A1- 2002 125 818
- CHENG GANG ET AL: "White organic light-emitting devices using a phosphorescent sensitizer" APPLIED PHYSICS LETTERS, AMERICAN INSTITUTE OF PHYSICS. NEW YORK, US, Bd. 82, Nr. 24, 16. Juni 2003 (2003-06-16), Seiten 4224-4226, XP012034359 ISSN: 0003-6951

## Beschreibung

Die vorliegende Erfindung beschreibt ein neuartiges Designprinzip für organische Elektrolumineszenzelemente und dessen Verwendung in darauf basierenden Displays.

In einer Reihe verschiedenartiger Anwendungen, die im weitesten Sinne der Elektronikindustrie zugerechnet werden können, ist der Einsatz organischer Halbleiter als funktionelle Materialien seit geraumer Zeit Realität bzw. wird in naher Zukunft erwartet. So finden schon seit etlichen Jahren lichtsensitive organische Materialien (z. B. Phthalocyanine) sowie organische Ladungstransportmaterialien (i. d. R. Lochtransporter auf Triarylaminbasis) Verwendung in Kopiergeräten.
Der Einsatz spezieller halbleitender organischer Verbindungen, die zum Teil auch zur Emission von Licht im sichtbaren Spektralbereich befähigt sind, steht gerade am Anfang der Markteinführung, zum Beispiel in organischen Elektrolumineszenzvorrichtungen. Deren Einzelbauteile, die organischen lichtemittierenden Dioden (OLEDs), besitzen ein sehr breites Anwendungsspektrum als:
1. weiße oder farbige Hinterleuchtungen für monochrome oder mehrfarbige Anzeigeelemente (wie z. B. Taschenrechner, Mobiltelefone und andere tragbare Anwendungen),
2. großflächige Anzeigen (wie z. B. Verkehrsschilder, Plakate und andere Anwendungen),
3. Beleuchtungselemente in allen Farben und Formen,
4. monochrome oder vollfarbige Passiv-Matrix-Displays für tragbare Anwendungen (wie z. B. Mobiltelefone, PDAs, Camcorder und andere Anwendungen),
5. vollfarbige, großflächige, hochauflösende Aktiv-Matrix-Displays für verschiedenste Anwendungen (wie z. B. Mobiltelefone, PDAs, Laptops, Fernseher und andere Anwendungen).
Bei diesen Anwendungen ist die Entwicklung teilweise bereits sehr weit fortgeschritten; dennoch besteht immer noch großer Bedarf an technischen Verbesserungen.

Für einfachere OLEDs enthaltende Vorrichtungen ist die Markteinführung bereits erfolgt, wie die Autoradios der Firma Pioneer, ein Mobiltelefon der Firma SNMD oder eine Digitalkamera der Firma Kodak mit "Organischem Display" belegen. Allerdings gibt es immer noch erhebliche Probleme, die einer dringenden Verbesserung bedürfen:
1. So ist v. a. die operative Lebensdauer von OLEDs immer noch gering, so daß bis dato nur einfache Anwendungen kommerziell realisiert werden können.
2. Diese relativ kurze Lebensdauer ergibt noch ein Folgeproblem: Gerade für Vollfarb-Anwendungen ("full-color-displays"), d. h. Displays, welche keine Segmentierungen aufweisen, sondern über die ganze Fläche alle Farben darstellen können, ist es besonders schlecht, wenn hier die einzelnen Farben unterschiedlich schnell altern, wie dies derzeit der Fall ist. Dies führt dazu, daß es schon vor Ende der o. g. Lebensdauer (die in der Regel durch einen Abfall auf 50 % der Anfangshelligkeit definiert ist) zu einer deutlichen Verschiebung des Weiß-Punkts kommt, d. h. die Farbechtheit der Darstellung im Display sehr schlecht wird. Um dies zu umgehen, definieren einige Displayhersteller die Lebensdauer als 70 % oder 90 %-Lebensdauer (d. h. Abfall der Anfangshelligkeit auf 70 % bzw. auf 90 % des Anfangswertes). Dies führt aber dazu, daß die Lebensdauer noch kürzer wird.
3. Die Effizienzen von OLEDs sind zwar akzeptabel, aber auch hier sind natürlich - gerade für tragbare Anwendungen ("portable applications") - immer noch Verbesserungen erwünscht.
4. Die Farbkoordinaten von OLEDs, speziell von breitbandig weiß emittierenden OLEDs bestehend aus allen drei Grundfarben, sind nicht gut genug. Besonders die Kombination von guten Farbkoordinaten mit hoher Effizienz muß noch verbessert werden.
5. Die Alterungsprozesse gehen i. d. R. mit einem Anstieg der Spannung einher. Dieser Effekt macht spannungsgetriebene organische Elektrolumineszenzvorrichtungen, z. B. Displays oder Anzeige-Elemente, schwierig bzw. unmöglich. Eine stromgetriebene Ansteuerung ist aber gerade in diesem Fall aufwendiger und teurer.
6. Die benötigte Betriebsspannung ist gerade bei effizienten phosphoreszierenden OLEDs recht hoch und muß daher weiter verringert werden, um die Leistungseffizienz zu verbessern. Das ist gerade für tragbare Anwendungen von großer Bedeutung.
7. Der benötigte Betriebsstrom ist ebenfalls in den letzten Jahren verringert worden, muß aber noch weiter verringert werden, um die Leistungseffizienz zu verbessern. Das ist gerade für tragbare Anwendungen besonders wichtig.

Die oben unter 1. bis 7. genannten Gründe machen Verbesserungen bei der Herstellung von OLEDs notwendig.

Eine Entwicklung hierzu, die sich in den letzten Jahren abzeichnet, ist der Einsatz metallorganischer Komplexe, die Phosphoreszenz statt Fluoreszenz zeigen [M. A. Baldo, S. Lamansky, P. E. Burrows, M. E. Thompson, S. R. Forrest, Applied Physics Letters, 1999, 75, 4-6].
Aus quantenmechanischen Gründen ist unter Verwendung metallorganischer Verbindungen eine bis zu vierfache Quanten-, Energie- und Leistungseffizienz möglich. Ob sich diese neue Entwicklung durchsetzen wird, hängt zum einen stark davon ab, ob entsprechende Device-Kompositionen gefunden werden können, die diese Vorteile (Triplett-Emission = Phosphoreszenz gegenüber Singulett-Emission = Fluoreszenz) auch in den OLEDs umsetzen können. Als wesentliche Bedingungen für praktische Anwendung sind hier insbesondere eine hohe operative Lebensdauer, eine hohe Stabilität gegenüber Temperaturbelastung und eine niedrige Einsatz- und Betriebsspannung, um mobile Applikationen zu ermöglichen, zu nennen.

Der allgemeine Aufbau von organischen Elektrolumineszenzvorrichtungen ist beispielsweise in US 4,539,507 und US 5,151,629 sowie EP 01202358 beschrieben. Üblicherweise besteht eine organische Elektrolumineszenzvorrichtung aus mehreren Schichten, die mittels Vakuummethoden oder unterschiedlicher Druckmethoden, insbesondere lösungsbasierte Druckmethoden, wie Ink-Jet-Druck, oder lösungsmittelfreie Druckmethoden, wie Thermotransfer-Druck oder LITI (Laser Induced Thermal Imaging) aufeinander aufgebracht werden. Diese Schichten sind im einzelnen:
1. Eine Trägerplatte = Substrat (üblicherweise Glas oder Kunststoffolie).
2. Eine transparente Anode (üblicherweise Indium-Zinn-Oxid, ITO).
3. Eine Lochinjektions-Schicht (**H**ole **I**njection **L**ayer = HIL): z. B. auf der Basis von Kupfer-phthalocyanin (CuPc) oder leitfähigen Polymeren, wie Polyanilin (PANI) oder Polythiophen-Derivaten (wie PEDOT).
4. Eine oder mehrere Lochtransport-Schichten (**H**ole **T**ransport **L**ayer = HTL): üblicherweise auf der Basis von Triarylamin-Derivaten z. B. 4,4',4"-Tris(N-1-naphthyl)-N-phenylamino)-triphenylamin (NaphDATA) als erste Schicht und N,N'-Di(naphth-1-yl)-N,N'-diphenylbenzidin (NPB) als zweite Lochtransportschicht.
5. Eine oder mehrere Emissions-Schichten (**E**mission **L**ayer = EML): diese Schicht (bzw. Schichten) kann teilweise mit den Schichten 4 bis 8 zusammenfallen, besteht aber üblicherweise aus mit Fluoreszenzfarbstoffen, z. B. N,N'-Diphenylchinacridon (QA), oder Phosphoreszenzfarbstoffen, z. B. Tris(phenylpyridyl)-iridium (Ir(PPy)₃) oder Tris(2-benzothiophenylpyridyl)-iridium (Ir(BTP)₃), dotierten Matrixmaterialien, wie 4,4'-Bis(carbazol-9-yl)-biphenyl (CBP). Die Emissions-Schicht kann aber auch aus Polymeren, Mischungen von Polymeren, Mischungen von Polymeren und niedermolekularen Verbindungen oder Mischungen verschiedener niedermolekularer Verbindungen bestehen.
6. Eine Lochblockier-Schicht (**H**ole-**B**locking-**L**ayer = HBL): diese Schicht kann teilweise mit den Schichten 7 und 8 zusammenfallen. Sie besteht üblicherweise aus BCP (2,9-Dimethyl-4,7-diphenyl-1,10-phenanthrolin = Bathocuproin) oder Bis-(2-methyl-8-chinolinolato)-4-(phenylphenolato)-aluminium(III) (BAIq).
7. Eine Elektronentransport-Schicht (**E**lectron **T**ransport **L**ayer = ETL): meist auf Basis von Aluminium-tris-8-hydroxychinolinolat (AlQ₃).
8. Eine Elektroneninjektions-Schicht (**E**lectron **I**njection **L**ayer = EIL): diese Schicht kann teilweise mit den Schichten 4, 5, 6 und 7 zusammenfallen, bzw. es wird ein kleiner Teil der Kathode speziell behandelt bzw. speziell abgeschieden.
9. Eine weitere Elektroneninjektions-Schicht (**E**lectron **I**njection **L**ayer = EIL): eine dünne Schicht bestehend aus einem Material mit einer hohen Dielektrizitätskonstanten, wie z. B. LiF, Li₂O, BaF₂, MgO, NaF.
10. Eine Kathode: hier werden in der Regel Metalle, Metallkombinationen oder Metallegierungen mit niedriger Austrittsarbeit verwendet, z. B. Ca, Ba, Cs, Mg, Al, In, Mg/Ag.

Diese ganze Vorrichtung wird entsprechend (je nach Anwendung) strukturiert, kontaktiert und schließlich auch hermetisch versiegelt, da sich die Lebensdauer derartiger Vorrichtungen bei Anwesenheit von Wasser und/oder Luft drastisch verkürzt. Das Gleiche gilt auch für sogenannte invertierte Strukturen, bei denen das Licht aus der Kathode ausgekoppelt wird. Bei diesen invertierten OLEDs besteht die Anode z.B aus Al/Ni/NiOx oder Al/Pt/PtOx oder anderen Metall/Metalloxid-Kombinationen, die ein HOMO größer 5 eV besitzen. Die Kathode besteht dabei aus den gleichen Materialien, die in Punkt 9 und 10 beschrieben sind, mit dem Unterschied, daß das Metall, wie z. B. Ca, Ba, Mg, Al, In usw., sehr dünn und damit transparent ist. Die Schichtdicke liegt unter 50 nm, besser unter 30 nm, noch besser unter 10 nm. Auf diese transparente Kathode kann noch ein weiteres transparentes Material aufgebracht werden, z. B. ITO (Indium-Zinn-Oxid), IZO (Indium-Zink-Oxid), usw..

Organische Elektrolumineszenzvorrichtungen, bei denen die Emissionsschicht (EML) aus mehr als einer Substanz besteht, sind schon seit längerem bekannt, ebenso organische Elektrolumineszenzvorrichtungen, bei denen mehr als eine Schicht zur Gesamtemission beiträgt und dabei eine Mischfarbe erzeugt:
- EP 1182244 beschreibt OLEDs, die weißes Licht emittieren, bei denen die fluoreszierenden Verbindungen aus der Gruppe der Fluoranthene, Pentacene oder Perylene stammt.
   Dabei wird die weiße Emission in einer Schicht aus zwei spektralen Komponenten erzeugt, blau und gelb-orange. Dies macht die weiß emittierende OLED ungeeignet, um mit Hilfe von Farbfiltern ein RGB-Display herzustellen, da der Rot-Anteil im Spektrum viel zu gering ist.
   Außerdem werden geringe Dotierungskonzentrationen von 0.1 - 2.6 % bei der Erzeugung der EML genannt. Dies ist in einer industriellen Fertigung von weiß emittierenden OLEDs nicht mit einer ausreichenden Reproduzierbarkeit zu verwirklichen, da bereits geringste Schwankungen in der Konzentration absolut und relativ einen extrem großen Einfluß auf die Farbe Weiß hat. So kann die Emissionsfarbe leicht ins Gelb-Orange oder Blaue verschoben werden.
   Die Farbe einer OLED hängt neben dem Dotierungsgrad bei geringen Konzentrationen eines Dotanden auch stark von der Betriebsspannung ab. Bei einer Erhöhung der Spannung, wie sie z. B. benötigt wird, um die Helligkeit zu erhöhen, beobachtet man häufig eine deutliche Verschiebung der Emission ins Blaue, was keineswegs eine Einhaltung des Weiß-Punktes über einen größeren Helligkeitsbereich möglich macht.
- EP 1286569 beschreibt OLEDs, die weißes Licht emittieren, bei denen die fluoreszierenden Verbindungen aus der Gruppe der Anthracene, Perylene, Tetracene oder anderen kondensierten Aromaten stammen. Dabei wird die weiße Emission aus zwei bis drei spektralen Komponenten erzeugt, blau, gelb-orange und teilweise auch noch grün. Dies macht auch hier die weiß emittierende OLED ungeeignet, um mit Hilfe von Farbfiltern ein RGB-Display herzustellen, da der Rot-Anteil im Spektrum viel zu gering ist.
   Außerdem werden geringe Dotierungskonzentrationen von 0.12 - 3 % bei der Erzeugung der EML genannt. Dies ist in einer industriellen Fertigung von weiß emittierenden OLEDs nicht mit ausreichender Reproduzierbarkeit zu verwirklichen, da eine geringe Schwankung in der Konzentration einen extrem großen Einfluß auf die Farbe Weiß hat. So kann die Emissionsfarbe leicht ins Gelb-Orange oder Blaue verschoben werden.
   Die maximale Effizienz beträgt hier 5 cd/A. Dabei werden für fluoreszierende OLEDs relativ hohe Spannungen - bis zu 7.5 V - beobachtet. Die hohen Spannungen entstehen hier, da entweder die HTL oder ETL mit einem fluoreszierenden Emitter dotiert werden. Dadurch werden sogenannte Traps gebildet, die die Transporteigenschaften dieser für den Transport bestimmten Schicht deutlich verschlechtern und die Betriebsspannung erhöhen.
- US 2003/0099860 beschreibt OLEDs, die weißes Licht emittieren, bei denen die fluoreszierenden Verbindungen ein Phenylen-Vinylen-Derivat (DPVBi), DCM2 und C6 sind. Dabei wird die weiße Emission aus zwei bis drei spektralen Komponenten erzeugt, blau, gelb-orange und grün. Dies macht auch hier die weiß emittierende OLED ungeeignet, um mit Hilfe von Farbfiltern ein RGB-Display herzustellen, da der Rot-Anteil im Spektrum viel zu gering ist. Außerdem werden geringe Dotierungskonzentrationen von 0.01 - 0.2 % bei der Erzeugung der EML genannt. Dies ist in einer industriellen Fertigung von weiß emittierenden OLEDs nicht mit ausreichender Reproduzierbarkeit zu verwirklichen, da eine geringe Schwankung in der Konzentration eine extrem großen Einfluß auf die Farbe Weiß hat. So kann die Emissionsfarbe leicht ins Gelb-Orange oder Blaue verschoben werden.
   Die Farbe einer OLED hängt neben dem Dotierungsgrad bei geringen Konzentrationen eines Dotanden auch von der Betriebsspannung stark ab. Bei einer Erhöhung der Spannung, wie sie z. B. benötigt wird, um die Helligkeit zu erhöhen, beobachtet man häufig eine deutliche Verschiebung der Emission ins Blaue, was keineswegs eine Einhaltung des Weiß-Punktes über einen größeren Helligkeitsbereich möglich macht.
   Auch hier wird die ETL mit einem fluoreszierenden Emitter dotiert, was zu einer Verschlechterung des Elektronentransports führt und die Betriebsspannungen unnötig erhöht.
- In WO 03/103341 werden weiß emittierende OLEDs beschrieben, die in der Emissionsschicht zwei oder mehr emittierende Verbindungen enthalten, von denen mindestens eine Verbindung phosphoresziert. Auch hier werden geringe Dotierungskonzentrationen in der EML genannt. Dies ist in einer industriellen Fertigung von weiß emittierenden OLEDs nicht mit ausreichender Reproduzierbarkeit zu realisieren. Weiterhin wird zwar aufgeführt, dass die OLEDs weißes Licht emittieren, aber da weder Farbkoordinaten noch Effizienzen angegeben sind, kann vermutet werden, dass diese nicht ausreichend gut sind.

Die Dokumente EP-A-1 154 498, US-A-6 166 489, WO 99/26730 A, CHENG GANG ET AL: "White organic light-emitting devices using a phosphorescent sensitizer" APPLIED PHYSICS LETTERS, AMERICAN INSTITUTE OF PHYSICS. NEW YORK, US, Bd. 82, Nr. 24, 16. Juni 2003 (2003-06-16), Seiten 4224-4226, WO 01/29909 A und US 2002/125818 offenbaren jeweils eine OLED mit zwei Emissionsschichten übereinander. Einige der Emissionsschichten enthalten einen phosphoreszierenden Emitter. Aus dieser Beschreibung des Stands der Technik ist klar, daß gerade die effiziente Erzeugung weißen Lichts (bzw. einer breitbandigen Emission) bis dato nicht ausreichend möglich ist. Es wurde nun überraschend gefunden, daß OLEDs, die die erfindungsgemäßen - im folgenden aufgeführten - Merkmale aufweisen, deutliche Verbesserungen gegenüber diesem Stand der Technik aufweisen.

Gegenstand der Erfindung ist deshalb eine organische Elektrolumineszenzvorrichtung gemäß Anspruch 1. Die organische Elektrolumineszenzvorrichtung kann außer den mindestens zwei Emissionsschichten auch weitere organische Schichten enthalten. Dies können beispielsweise eine oder mehrere Lochinjektions- und/oder Lochtransportschichten sein. Ebenso können eine oder mehrere Elektroneninjektions- und/oder Elektronentransportschichten anwesend sein. Eine nicht erfindungsgemäße OLED wird durch das nachfolgende Schema illustriert, wobei, wie oben beschrieben, nicht notwendigerweise eine ETL bzw. HTL bzw. HIL vorhanden sein muss bzw. andererseits auch mehrere solche Schichten vorhanden sein können:

| |
|---|
| Kathode |
| ETL |
| HBL |
| EML2 |
| EML1 |
| HTL2 |
| HTL1 |
| HIL |
| Anode |

Werden die lichtemittierenden Materialien in diesen Emissionsschichten derartig gewählt, daß mindestens eine blaue, grüne und rote, bevorzugt mindestens eine tiefblaue, tiefgrüne und tiefrote Komponente vorhanden ist, lassen sich alle gewünschten Farben besonders gut einstellen. Über die Variation der einzelnen Schichtdicken können alle durch die Grundfarben enthaltenen Farben erzeugt und eingestellt werden.

Zur Emission befähigt im Sinne der Erfindung bedeutet, daß die emittierende Substanz als reiner Film oder gegebenenfalls als Dotand in einem Matrixmaterial in einer OLED eine Emission von Licht im Bereich von 380 nm bis 750 nm zeigt.

Bevorzugt zeigt jede Emissionsschicht für sich die Emission genau eines Emitters.

Eine bevorzugte Ausführungsform ist eine oben beschriebene OLED mit drei gegeneinander abgegrenzten Emissionsschichten. Eine nicht erfindungsgemäße OLED wird durch das nachfolgende Schema illustriert, wobei, wie oben beschrieben, nicht notwendigerweise eine ETL bzw. HTL bzw. HIL vorhanden sein muss bzw. andererseits auch mehrere solche Schichten vorhanden sein können:

| |
|---|
| Kathode |
| ETL |
| HBL |
| EML3 |
| EML2 |
| EML1 |
| HTL2 |
| HTL1 |
| HIL |
| Anode |

Über die Variation der einzelnen Schichtdicken können alle in diesem Farbdreieck enthaltenen Farben erzeugt und eingestellt werden.

Eine bevorzugte Ausführungsform ist eine wie im vorherigen Abschnitt beschriebene OLED mit roter, grüner und blauer Emissionsschicht. Über die Variation der einzelnen Schichtdicken der blauen, grünen und oder roten Schicht können alle in diesem Farbdreieck enthaltenen Farben erzeugt und eingestellt werden. Der Farbeindruck Weiß läßt sich so besonders gut erzeugen.

Eine Emissionsschicht (EML) im Sinne der Erfindung umfaßt sowohl Schichten, in denen Emitter als reine Materialien vorliegen, als auch Schichten, in denen mehrere Verbindungen in einem Dotand-Matrix-System vorliegen, wobei das Gewichtsverhältnis von Matrixmaterial zu Emitter 99:1 bis 1:99, bevorzugt 95:5 bis 5:95 beträgt.

Eine bevorzugte Ausführungsform ist eine oben beschriebene OLED, dadurch gekennzeichnet, daß als phosphoreszierender Emitter eine Verbindung enthalten ist, die mindestens ein Atom der Ordnungszahl größer 38 und kleiner 84, bevorzugt größer 56 und kleiner 80 aufweist.

Eine besonders bevorzugte Ausführungsform ist eine oben beschriebene OLED, enthaltend als Emitter mindestens eine Verbindung, dadurch gekennzeichnet, daß das Element der Ordnungszahl größer 56 und kleiner 80 Molybdän, Wolfram, Rhenium, Ruthenium, Osmium, Rhodium, Iridium, Palladium, Platin, Silber, Gold oder Europium ist, beispielsweise gemäß den Patentanmeldungen WO 98/01011, US 02/0034656, US 03/0022019, WO 00/70655, WO 01/41512, WO 02/02714, WO 02/15645, EP 1191613, EP 1191612, EP 1191614, WO 03/040257 und WO 03/084972.

Eine bevorzugte Ausführungsform ist eine oben beschriebene OLED, dadurch gekennzeichnet, daß der phosphoreszierende Emitter in eine oder mehrere Matrices, die in den Patentanmeldungen WO 00/057676, EP 01/202358, WO 02/074015, DE 10317556.3 und DE 10330761.3 offenbart werden, eindotiert wird. Neben den vorstehend zitierten Materialien sind auch Silane als weitere Matrixmaterialien geeignet.

Eine weitere bevorzugte Ausführungsform ist eine oben beschriebene OLED, dadurch gekennzeichnet, daß mindestens eine der Emissionsschichten einen nicht-phosphoreszierenden Emitter aufweist. Besonders bevorzugt ist hierbei eine Emissionsschicht auf Elektrofluoreszenz-Basis, insbesondere eine im blauen Spektralbereich.
Eine besonders bevorzugte Ausführungsform ist hierbei eine OLED, enthaltend einen nicht-phosphoreszierenden Emitter aus den Klassen der Styrylamine, beispielsweise gemäß den Patentanmeldungen EP 01314715 und EP 1167488, der Cumarine, Anthracene, Pyrene, Perylene, Oligoacene, Dicyanomethane, beispielsweise gemäß den Patentanmeldungen EP 1182244, EP 1286569 und WO 00/0121729, der Spiro-Verbindungen, beispielsweise gemäß den Patentanmeldungen EP 676461 und WO 99/40051, und Heterocyclen, beispielsweise gemäß der Patentanmeldung WO 04/002970, oder die in der Patentanmeldung DE 10310887.4 beschriebenen Komplexe und weitere fluoreszente Emitter.

Eine Ausführungsform der Erfindung ist eine oben beschriebene OLED, dadurch gekennzeichnet, daß zwischen mindestens zwei Emissionsschichten mindestens eine lochblockierende Schicht (HBL) enthalten ist.

Diese Ausführungsform ist im nachfolgenden Schema illustriert, wobei, wie oben beschrieben, nicht notwendigerweise eine ETL bzw. HTL bzw. HIL vorhanden sein muss bzw. andererseits auch mehrere solche Schichten vorhanden sein können:

| |
|---|
| Kathode |
| ETL |
| HBL3 |
| EML3 |
| HBL2 |
| EML2 |
| HBL1 |
| EML1 |
| HTL2 |
| HTL1 |
| HIL |
| Anode |

Eine bevorzugte Ausführungsform ist eine oben beschriebene OLED, dadurch gekennzeichnet, daß als lochblockierende Materialien (HBM) Verbindungen aus den Klassen der Azaphenanthrene (z. B. BCP), beispielsweise gemäß der Patentanmeldung US 02/0034656, der Metall-Chelat-Komplexe (z. B. B-Alq), beispielsweise gemäß den Patentanmeldungen EP 01308494 und WO 03/022007, bestimmte Metall-Komplexe, beispielsweise gemäß der Patentanmeldung DE 10310887.4, und der Spirophenylene, beispielsweise gemäß den Patentanmeldungen EP 676461, WO 99/40051 und DE 10357317.8 verwendet werden.

Eine Ausführungsform der Erfindung ist eine oben beschriebene OLED, dadurch gekennzeichnet, daß zusätzlich zwischen mindestens zwei Emissionsschichten mindestens eine elektronenblockierende Schicht (EBL) enthalten ist, wobei, wie oben beschrieben, nicht notwendigerweise eine ETL bzw. HTL bzw. HIL vorhanden sein muss bzw. andererseits auch mehrere solche Schichten vorhanden sein können.

| |
|---|
| Kathode |
| ETL |
| EBL3 |
| EML3 |
| EBL2 |
| EML2 |
| EBL1 |
| EML1 |
| HTL2 |
| HTL1 |
| HIL |
| Anode |

Eine bevorzugte Ausführungsform ist eine oben beschriebene OLED, dadurch gekennzeichnet, daß zusätzlich zwischen mindestens zwei Emissionsschichten mindestens eine elektronenblockierende Schicht (EBL) und mindestens eine lochblockierende Schicht (HBL) enthalten ist

Diese Ausführungsform ist in den nachfolgenden Schemata illustriert, wobei, wie oben beschrieben, nicht notwendigerweise eine ETL bzw. HTL bzw. HIL vorhanden sein muss bzw. andererseits auch mehrere solche Schichten vorhanden sein können:

| |
|---|
| Kathode |
| ETL |
| HBL2 |
| EML3 |
| HBL1 |
| EML2 |
| EBL1 |
| EML1 |
| HTL2 |
| HTL1 |
| HIL |
| Anode |

| |
|---|
| Kathode |
| ETL |
| HBL2 |
| EML3 |
| HBL1 |
| EML2 |
| EBL2 |
| EML1 |
| EBL1 |
| HTL2 |
| HTL1 |
| HIL |
| Anode |

Eine bevorzugte Ausführungsform ist eine oben beschriebene OLED, dadurch gekennzeichnet, daß als elektronenblockierende Materialien (EBM) Verbindungen aus den Klassen der Triarylamine, beispielsweise gemäß den Patentanmeldungen EP 01314715 und EP 1167488, der Spiro-Triarylamine, beispielsweise gemäß den Patentanmeldungen WO 97/10617, WO 99/12888 und EP 968175, und der Phthalocyanine, beispielsweise gemäß WO 03/022007, verwendet werden.

Bei den erfindungsgemäßen OLEDs werden die Schichtdicken der voneinander abgegrenzten Emissionsschichten in der Regel im Bereich von 1 bis 150 nm, bevorzugt im Bereich von 3 bis 100 nm, besonders bevorzugt im Bereich 5 bis 50 nm gewählt.

Bei den erfindungsgemäßen OLEDs werden die Schichtdicken der Lochtransport-, sowie der Elektronentransport- und Lochblockierschichten, sofern vorhanden, in der Regel im Bereich von 1 bis 150 nm gewählt.

Bevorzugte Ausführungen der erfindungsgemäßen OLEDs sind solche, bei denen die Glastemperatur T_{g} der jeweiligen Dotanden größer als 90 °C ist, bevorzugt größer als 100 °C, besonders bevorzugt größer als 120 °C.

Eine ebenfalls bevorzugte Ausführung ist dann gegeben, wenn die Glastemperatur T_{g} der jeweiligen Matrix größer als 90 °C, bevorzugt größer als 120 °C, besonders bevorzugt größer als 130 °C ist.

Besonders bevorzugt ist es, wenn die beschriebene hohe Glastemperatur sowohl von den Matrixmaterialien und Lochblockiermaterialien, als auch von den Emissionsmaterialien und Dotanden gleichzeitig vorliegt.

Die oben beschriebenen breitbandig emittierenden Vorrichtungen weisen folgende überraschende Vorteile gegenüber dem Stand der Technik auf:
1. Die Effizienz entsprechender Vorrichtungen wird im Vergleich zu Systemen, die nicht dem erfindungsgemäßen Design folgen, höher.
2. Die Farbkoordinaten bzw. die Farbwiedergabe, beschrieben durch den Color-Rendering Index (CRI), wird besser, da eine breitbandige Emission erzeugt wird, die sich von tiefblau bis tiefrot erstreckt. Eine Verwendung von Farbfiltern zur Erzeugung eines RGB-Displays ist gut möglich.
3. Die Konzentration der Dotanden beeinflußt kaum die Farbkoordinaten.
4. Die Toleranz der Emissionsfarbe bezüglich des Betriebsstroms bzw. der Betriebsspannung ist sehr groß.
5. Die Betriebsspannung wird nicht erhöht.
6. Mit tiefroten und effizienten phosphoreszierenden Emittern (wie z. B. Ir(piq) 3) sind die Filterverluste bei Rot sehr gering und somit die Effizienz sehr hoch.
7. Mit tiefgrünen und effizienten phosphoreszierenden Emittern (wie z. B. Ir(PPy)₃) sind die Filterverluste bei Grün sehr gering und somit die Effizienz sehr hoch.
8. Mit blauen und effizienten phosphoreszierenden Emittern (wie z. B. Ir(F₂CNPPy)₃) sind die Filterverluste bei Blau sehr gering und somit die Effizienz sehr hoch.
9. Mit tiefblauen und effizienten fluoreszierenden sind die Filterverluste bei Blau sehr gering und somit die Effizienz sehr hoch.

Der erfindungsgemäße Device-Aufbau läßt sich mit verschiedenen Applikationsmethoden erreichen. Einerseits ist es möglich, alle Schichten im Vakuum aufzubringen, andererseits lassen sich einzelne Schichten aus Lösung aufbringen, gefolgt von Schichten, die wiederum im Vakuum appliziert werden. Es ist auch möglich, alle Schichten aus Lösung aufzutragen. Beim Aufbringen im Vakuum dienen Schattenmasken zum Strukturieren, während aus Lösung vor allem unterschiedliche Druck-Verfahren anwendbar sind. Druck-Verfahren im Sinne der Erfindung umfassen auch solche, die vom Festkörper ausgehen, wie Thermotransferdruck oder LITI. Im Falle der lösungsmittelbasierten Verfahren werden Lösungsmittel eingesetzt, welche die eingesetzten Stoffe lösen. Die Art des Stoffes ist für die Erfindung nicht maßgeblich. Es können Stoffe mit Molekulargewichten < 1500 g/mol bevorzugt eingesetzt werden, wenn Vakuumapplikation gewählt wird. Bei MW > 1500 g/mol sind polymere Stoffe (linear, verzweigt, hyperverzweigt, dendritisch, macrocyclisch) einsetzbar. Es hat sich auch als nützlich erwiesen, vernetzbare Stoffe einzusetzen, wobei die Möglichkeit zur Photostrukturierung besteht.

Details zu den hier gemachten Angaben finden sich in den unten beschriebenen Beispielen.

### Beispiele

### Herstellung und Charakterisierung von organischen Elektrolumineszenzvorrichtungen, die dem erfindungsgemäßen Aufbau entsprechen.

Die Herstellung von OLEDs erfolgte nach einem allgemeinen Verfahren, das beispielsweise in der nicht offengelegten Anmeldung DE 10317556.3 beschrieben ist. Dieses muß im Einzelfall auf die jeweiligen Gegebenheiten (z. B. Schichtdickenvariation, um optimale Effizienz bzw. Farbe zu erreichen) angepaßt werden.

Die für die Erfindung wesentliche Emissions-Schicht (**E**mission **L**ayer = EML) umfaßt mindestens zwei Einzelschichten, die jeweils eine andere Emissionsfarbe aufweisen und aufeinander aufgebracht werden. Zwischen diesen Einzelschichten sind auch andere Schichten, wie z. B. Lochblockierschichten, oder Elektronblockierschichten wie vorne beschrieben. Die Einzelschichten bestehen z. B. aus einem niedermolekularen Wirtsmaterial und einem niedermolekularen Gastmaterial, dem lichtemittierenden Dotanden, wie beispielsweise CBP oder anderen Matrixmaterialien als Wirtsmaterial und Ir(PPy)₃ als Dotand im Falle der grünen Emitterschicht. Anstelle von niedermolekularen lichtemittierenden Verbindungen können auch hochmolekulare lichtemittierende Verbindungen (Polymere) verwendet werden, wobei eine oder auch beide Komponenten des Wirts-Gast-Systems hochmolekular sein können.

### Device-Beispiele:

In diesen Beispielen werden die Ergebnisse verschiedener OLEDs vorgestellt. Der grundlegende Aufbau, wie die verwendeten Materialien und Schichtdicken, außer der EML und den HBLs, waren zur besseren Vergleichbarkeit identisch. Es wurde ausschließlich der Aufbau der EML und dazugehörige HBLs in den Beispielen variiert.

Analog dem o. g. allgemeinen Verfahren wurden breitbandig emittierende OLEDs mit folgendem Aufbau erzeugt:
- PEDOT: 60 nm (aus Wasser aufgeschleudert; PEDOT bezogen von H. C. Starck; Poly-[3,4-ethylendioxy-2,5-thiophen]
- NaphDATA: 20 nm (aufgedampft; NaphDATA bezogen von SynTec; 4,4',4"-Tris(N-2-naphthyl)-N-phenylamino)-triphenylamin
- S-TAD: 20 nm (aufgedampft; S-TAD hergestellt nach WO99/12888; 2,2',7,7'-Tetrakis(diphenylamino)-spirobifluoren)
- Emitter-Schicht:: genauer Aufbau siehe Beispiele
- HBM: siehe Beispiele
- AlQ₃: 10 nm (aufgedampft: AlQ₃ bezogen von SynTec; Tris(chinolinolato)aluminium(III))
- Ba-Al: 3 nm Ba darauf 150 nm Al als Kathode

Diese noch nicht optimierten OLEDs wurden standardmäßig charakterisiert; hierfür wurden die Elektrolumineszenzspektren, die Effizienz (gemessen in cd/A) in Abhängigkeit von der Helligkeit, berechnet aus Strom-Spannungs-Helligkeit-Kennlinien (IUL-Kennlinien), und die Lebensdauer bestimmt.

In Tabelle 1 sind die Ergebnisse der Beispiele 1 bis 4 zusammengefaßt. Die Zusammensetzung der gesamten EMLs und HBLs inklusive der entsprechenden Schichtdicken, ist aufgeführt. Die dotierten phosphoreszierenden EML enthalten alle als Matrixmaterial Bis(9,9'-spirobifluoren-2-yl)keton (Synthese gemäß DE 10317556.3); in Tabelle 1 ist lediglich der Emitter aufgeführt. Die in Tabelle 1 verwendeten Abkürzungen entsprechen den folgenden Verbindungen:

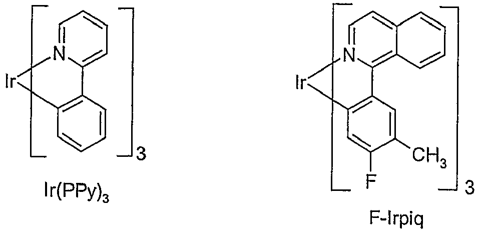

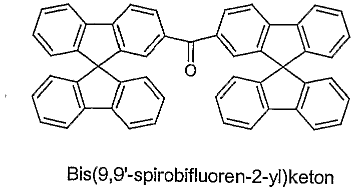

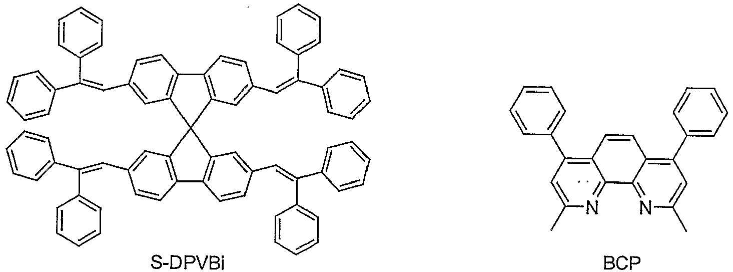

**Tabelle 1**

| Beispiel | EML1 | HBL1 | EML2 | HBL2 | EML3 | HBL3 | Effizienz (cd/A) | Spannung (V) bei 100 cd/m² | CIE |
|---|---|---|---|---|---|---|---|---|---|
| Beispiel 1 | S-DPVBi (10nm) | | 20% F-Irpiq (10nm) | - | 20% Ir(ppy)₃ (10nm) | BCP (10nm) | 12 | 8.5 | x=0.31; y=0.33 (vgl. Fig.1) |
| Beispiel 2 | S-DPVBi (10nm) | | 20% Ir(ppy)₃ (10nm) | BCP (4nm) | 20% F-Irpiq (10nm) | BCP (8nm) | 15 | 8.0 | x=0.33; y=0.36 (vgl. Fig.2) |
| Beispiel 3 | S-DPVBi (10nm) | | 20% F-Irpiq (10nm) | BCP (8nm) | | | 8 | 8.0 | x=0.34; y=0.28 (vgl. Fig.3) |
| Beispiel 4 | S-DPVBi (10nm) | BCP (5nm) | 20% Ir(ppy)₃ (10nm) | BCP (5nm) | 20% F-Irpiq (10nm) | BCP (10nm) | 18 | 8.5 | x=0.36; y=0.39 |

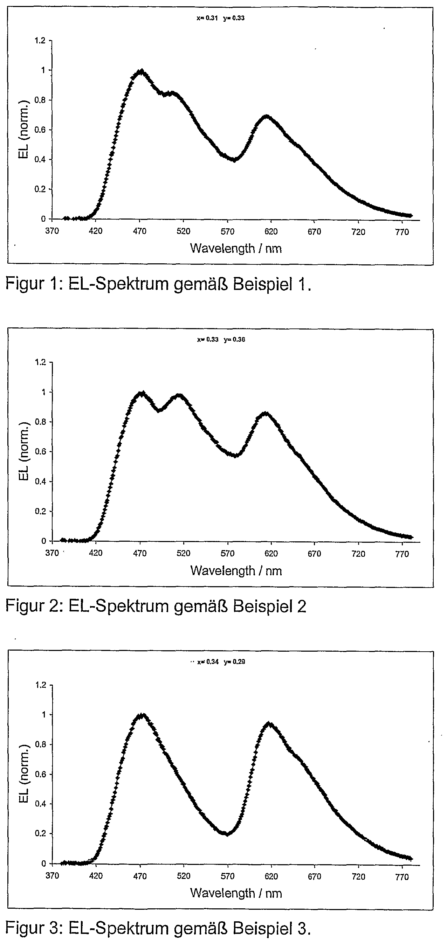

Zusammenfassend kann gesagt werden, daß bei allen OLEDs eine rein weiße Emission, resultierend aus allen enthaltenen Emittern, zu beobachten war. Die entsprechenden Emissionsspektren sind unten aufgeführt (Figur 1 bis 3).

### Beispiel 5: Farbe in Abhängigkeit des Stroms

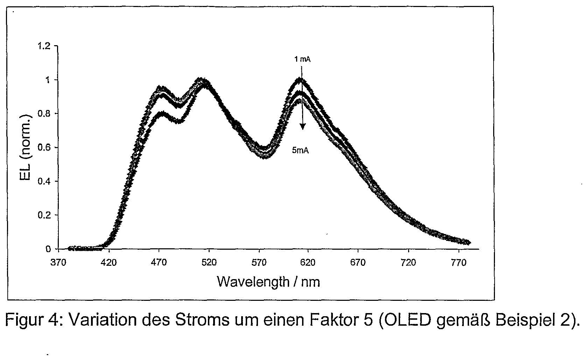

Exemplarisch soll anhand der Emissionsspektren die Stabilität der Farbe gegenüber einer Erhöhung der Spannung bzw. des Stromes gezeigt werden. Dabei wurde eine OLED gemäß Beispiel 2 verwendet. In Figur 4 sind drei Spektren dargestellt, bei denen der Strom von 1 mA über 3 mA auf 5 mA erhöht wurde. Dabei änderten sich die CIE-Koordinaten von x = 0.36, y = 0.39 auf x = 0.33, y = 0.36, was nur einer sehr geringen Änderung entspricht.

## Patentansprüche

1. Organische Elektrolumineszenzvorrichtung enthaltend Kathode, Anode und mindestens zwei gegeneinander abgegrenzte Emissionsschichten, welche übereinander angeordnet sind, welche verschiedene Lichtwellenlängen emittieren und wobei in mindestens einer Emissionsschicht mindestens ein phosphoreszierender Emitter enthalten ist, **dadurch gekennzeichnet, dass** zwischen mindestens zwei emittierenden Schichten mindestens eine lochblockierende Schicht (HBL) oder
eine elektronenblockierende Schicht (EBL) enthalten ist.

2. Organische Elektroluminenszenzvorrichtung gemäß Anspruch 1, **dadurch gekennzeichnet, dass** weitere Schichten vorhanden sind.

3. Organische Elektrolumineszenzvorrichtung gemäß Anspruch 2, **dadurch gekennzeichnet, dass** es sich bei den weiteren Schichten um Lochinjektions- und/oder Lochtransportschichten handelt.

4. Organische Elektrolumineszenzvorrichtung gemäß Anspruch 2 und/oder 3, **dadurch gekennzeichnet, dass** es sich bei den weiteren Schichten um Elektroneninjektions- und/oder Elektronentransportschichten handelt.

5. Organische Elektrolumineszenzvorrichtung gemäß einem oder mehreren der Ansprüche 1 bis 4, **dadurch gekennzeichnet, daß** sie eine Emission von Licht im Bereich von 380 nm bis 750 nm zeigt.

6. Organische Elektrolumineszenzvorrichtung gemäß einem oder mehreren der Ansprüche 1 bis 5, **dadurch gekennzeichnet, daß** sie drei gegeneinander abgegrenzte Emissionsschichten, welche übereinander angeordnet sind, aufweist.

7. Organische Elektrolumineszenzvorrichtung gemäß einem oder mehreren der Ansprüche 1 bis 6, **dadurch gekennzeichnet, daß** die drei gegeneinander abgegrenzten Emissionsschichten die Emissionsfarben Rot, Grün und Blau aufweisen.

8. Organische Elektrolumineszenzvorrichtung gemäß einem oder mehreren der Ansprüche 1 bis 7, **dadurch gekennzeichnet, daß** die Emissionsschichten sowohl Schichten, in denen Emitter als reine Materialien vorliegen, als auch Schichten umfaßt, in denen mehrere Verbindungen in einem Dotand-Matrix-System vorliegen, wobei das Gewichtsverhältnis von Matrixmaterial zu Emitter 99:1 bis 1:99 beträgt.

9. Organische Elektrolumineszenzvorrichtung gemäß einem oder mehreren der Ansprüche 1 bis 8, **dadurch gekennzeichnet, daß** als phosphoreszierender Emitter eine Verbindung enthalten ist, die mindestens ein Atom der Ordnungszahl größer 38 und kleiner 84 aufweist.

10. Organische Elektrolumineszenzvorrichtung gemäß Anspruch 9, **dadurch gekennzeichnet, daß** der phosphoreszierende Emitter Molybdän, Wolfram, Rhenium, Ruthenium, Osmium, Rhodium, Iridium, Palladium, Platin, Silber, Gold oder Europium enthält.

11. Organische Elektrolumineszenzvorrichtung gemäß einem oder mehreren der Ansprüche 1 bis 10, **dadurch gekennzeichnet, daß** mindestens eine der Emissionsschichten mindestens einen nicht-phosphoreszierenden Emitter enthält.

12. Organische Elektrolumineszenzvorrichtung gemäß Anspruch 11, enthaltend mindestens einen nicht-phosphoreszierenden Emitter aus den Klassen der Styrylamine, Cumarine, Anthracene, Pyrene, Perylene, Oligoacene, Dicyanomethane, Verbindungen mit Spiro-Zentren, Heterocyclen oder Metall-Komplexe.

13. Organische Elektrolumineszenzvorrichtung gemäß Anspruch 1, **dadurch gekennzeichnet, daß** als lochblockierende Materialien (HBM) Verbindungen aus den Klassen der Azaphenanthrene, Metall-Chelat-Komplexe, Metall-Komplexe oder Spiro-phenylene verwendet werden.

14. Organische Elektrolumineszenzvorrichtung gemäß Anspruch 1, **dadurch gekennzeichnet, daß** als elektronenblockierende Materialien (EBM) Verbindungen aus den Klassen der Triarylamine, Spiro-Triarylamine oder der Phthalocyanine verwendet werden.

15. Organische Elektrolumineszenzvorrichtung gemäß einem oder mehreren der Ansprüche 1 bis 14, **dadurch gekennzeichnet, daß** zwischen mindestens zwei Emissionsschichten mindestens eine elektronenblockierende Schicht (EBL) und mindestens eine lochblockierende Schicht (HBL) enthalten ist.

16. Organische Elektrolumineszenzvorrichtung gemäß einem oder mehreren der Ansprüche 1 bis 15, **dadurch gekennzeichnet, daß** die Schichtdicke der voneinander abgegrenzten Emitterschichten eine Dicke von 1 bis 150 nm aufweisen.

17. Organische Elektrolumineszenzvorrichtung gemäß einem oder mehreren der Ansprüche 1 bis 16, **dadurch gekennzeichnet, daß** die Schichtdicke der Elektronentransport- und Lochblockierschichten eine Dicke von 1 bis 150 nm aufweisen.

18. Organische Elektrolumineszenzvorrichtung gemäß einem oder mehreren der Ansprüche 1 bis 17 **dadurch gekennzeichnet, daß** die Schichtdicke der Elektronentransport- und Lochblockier- und Emitter-Schichten jeweils eine unterschiedliche Dicke im Bereich von 1 bis 150 nm aufweisen.

19. Organische Elektrolumineszenzvorrichtung gemäß einem oder mehreren der Ansprüche 1 bis 18, **dadurch gekennzeichnet, daß** die Glastemperatur T_{g} des Emitters größer als 90 °C ist.

20. Organische Elektrolumineszenzvorrichtung gemäß einem oder mehreren der Ansprüche 1 bis 19, **dadurch gekennzeichnet, daß** die Glastemperatur T_{g} der Matrixmaterialien der Emissionsschichten größer als 100 °C ist.

21. Organische Elektrolumineszenzvorrichtung gemäß einem oder mehreren der Ansprüche 1 bis 20, **dadurch gekennzeichnet, daß** die Glastemperatur T_{g} aller verwendeten Materialien in allen Schichten größer als 90 °C ist.

## Claims

1. Organic electroluminescent device comprising cathode, anode and at least two mutually delimited emission layers which are arranged one above the other and which emit different wavelengths of light and where at least one emission layer comprises at least one phosphorescent emitter, **characterised in that** at least one hole-blocking layer (HBL) or electron-blocking layer (EBL) is present between at least two emitting layers.

2. Organic electroluminescent device according to Claim 1, **characterised in that** further layers are present.

3. Organic electroluminescent device according to Claim 2, **characterised in that** the further layers are hole-injection and/or hole-transport layers.

4. Organic electroluminescent device according to Claim 2 and/or 3, **characterised in that** the further layers are electron-injection and/or electron-transport layers.

5. Organic electroluminescent device according to one or more of Claims 1 to 4, **characterised in that** it exhibits light emission in the range from 380 nm to 750 nm.

6. Organic electroluminescent device according to one or more of Claims 1 to 5, **characterised in that** it has three mutually delimited emission layers which are arranged one above the other.

7. Organic electroluminescent device according to one or more of Claims 1 to 6, **characterised in that** the three mutually delimited emission layers have the emission colours red, green and blue.

8. Organic electroluminescent device according to one or more of Claims 1 to 7, **characterised in that** the emission layers include both layers in which emitters are present in the form of pure materials and also layers in which a plurality of compounds are present in a dopant/ matrix system, where the weight ratio of matrix material to emitter is 99:1 to 1:99.

9. Organic electroluminescent device according to one or more of Claims 1 to 8, **characterised in that** the phosphorescent emitter present is a compound which has at least one atom having an atomic number greater than 38 and less than 84.

10. Organic electroluminescent device according to Claim 9, **characterised in that** the phosphorescent emitter contains molybdenum, tungsten, rhenium, ruthenium, osmium, rhodium, iridium, palladium, platinum, silver, gold or europium.

11. Organic electroluminescent device according to one or more of Claims 1 to 10, **characterised in that** at least one of the emission layers comprises at least one non-phosphorescent emitter.

12. Organic electroluminescent device according to Claim 11, comprising at least one non-phosphorescent emitter from the classes of the styrylamines, coumarins, anthracenes, pyrenes, perylenes, oligo-acenes, dicyanomethanes, compounds having spiro centres, heterocycles or metal complexes.

13. Organic electroluminescent device according to Claim 1, **characterised in that** the hole-blocking materials (HBM) used are compounds from the classes of the azaphenanthrenes, metal chelate complexes, metal complexes or spiro-phenylenes.

14. Organic electroluminescent device according to Claim 1, **characterised in that** the electron-blocking materials (EBM) used are compounds from the classes of the triarylamines, spiro-triarylamines or phthalocyanines.

15. Organic electroluminescent device according to one or more of Claims 1 to 14, **characterised in that** at least one electron-blocking layer (EBL) and at least one hole-blocking layer (HBL) are present between at least two emission layers.

16. Organic electroluminescent device according to one or more of Claims 1 to 15, **characterised in that** the mutually delimited emitter layers have a thickness of 1 to 150 nm.

17. Organic electroluminescent device according to one or more of Claims 1 to 16, **characterised in that** the electron-transport and hole-blocking layers have a thickness of 1 to 150 nm.

18. Organic electroluminescent device according to one or more of Claims 1 to 17, **characterised in that** the electron-transport and hole-blocking and emitter layers each have a different thickness in the range from 1 to 150 nm.

19. Organic electroluminescent device according to one or more of Claims 1 to 18, **characterised in that** the glass transition temperature T_{g} of the emitter is greater than 90°C.

20. Organic electroluminescent device according to one or more of Claims 1 to 19, **characterised in that** the glass transition temperature T_{g} of the matrix materials of the emission layers is greater than 100°C.

21. Organic electroluminescent device according to one or more of Claims 1 to 20, **characterised in that** the glass transition temperature T_{g} of all materials used in all layers is greater than 90°C.

## Revendications

1. Dispositif électroluminescent organique comprenant une cathode, une anode et au moins deux couches d'émission de lumière mutuellement délimitées qui sont agencées l'une au-dessus de l'autre ou les unes au-dessus des autres et qui émettent des longueurs d'onde de lumière différentes et où au moins une couche d'émission comprend au moins un émetteur phosphorescent, **caractérisé en ce qu'**au moins une couche de blocage de trous (HBL) ou une couche de blocage d'électrons (EBL) est présente entre au moins deux couches d'émission.

2. Dispositif électroluminescent organique selon la revendication 1, **caractérisé en ce que** d'autres couches sont présentes.

3. Dispositif électroluminescent organique selon la revendication 2, **caractérisé en ce que** les autres couches sont des couches d'injection de trous et/ou de transport de trous.

4. Dispositif électroluminescent organique selon la revendication 2 et/ou 3, **caractérisé en ce que** les autres couches sont des couches d'injection d'électrons et/ou de transport d'électrons.

5. Dispositif électroluminescent organique selon une ou plusieurs des revendications 1 à 4, **caractérisé en ce qu'**il présente une émission de lumière dans la plage de 380 nm à 750 nm.

6. Dispositif électroluminescent organique selon une ou plusieurs des revendications 1 à 5, **caractérisé en ce qu'**il comporte trois couches d'émission de lumière mutuellement délimitées qui sont agencées les unes au-dessus des autres.

7. Dispositif électroluminescent organique selon une ou plusieurs des revendications 1 à 6, **caractérisé en ce que** les trois couches d'émission mutuellement délimitées présentent les couleurs d'émission rouge, vert et bleu.

8. Dispositif électroluminescent organique selon une ou plusieurs des revendications 1 à 7, **caractérisé en ce que** les couches d'émission incluent à la fois des couches dans lesquelles des émetteurs sont présents sous la forme de matériaux purs et également des couches dans lesquelles une pluralité de composés sont présents selon un système dopant/matrice, où le rapport en poids matériau de matrice sur émetteur est de 99:1 à 1:99.

9. Dispositif électroluminescent organique selon une ou plusieurs des revendications 1 à 8, **caractérisé en ce que** l'émetteur phosphorescent présent est un composé qui comporte au moins un atome qui présente un numéro atomique supérieur à 38 et inférieur à 84.

10. Dispositif électroluminescent organique selon la revendication 9, **caractérisé en ce que** l'émetteur phosphorescent contient du molybdène, du tungstène, du rhénium, du ruthénium, de l'osmium, du rhodium, de l'iridium, du palladium, du platine, de l'argent, de l'or ou de l'europium.

11. Dispositif électroluminescent organique selon une ou plusieurs des revendications 1 à 10, **caractérisé en ce qu'**au moins l'une des couches d'émission comprend au moins un émetteur non phosphorescent.

12. Dispositif électroluminescent organique selon la revendication 11, comprenant au moins un émetteur non phosphorescent pris parmi les classes des styrylamines, des coumarines, des anthracènes, des pyrènes, des pérylènes, des oligoacènes, des dicyanométhanes, des composés qui comportent des centres spiro, des hétérocycles ou des complexes métalliques.

13. Dispositif électroluminescent organique selon la revendication 1, **caractérisé en ce que** les matériaux de blocage de trous (HBM) qui sont utilisés sont des composés pris parmi les classes des azaphén-anthrènes, des complexes de chélates métalliques, des complexes métalliques ou des spiro-phénylènes.

14. Dispositif électroluminescent organique selon la revendication 1, **caractérisé en ce que** les matériaux de blocage d'électrons (EBM) qui sont utilisés sont des composés pris parmi les classes des triarylamines, des spiro-triarylamines ou des phthalocyanines.

15. Dispositif électroluminescent organique selon une ou plusieurs des revendications 1 à 14, **caractérisé en ce qu'**au moins une couche de blocage d'électrons (EBL) et au moins une couche de blocage de trous (HBL) sont présentes entre au moins deux couches d'émission.

16. Dispositif électroluminescent organique selon une ou plusieurs des revendications 1 à 15, **caractérisé en ce que** les couches d'émetteur mutuellement délimitées présentent une épaisseur de 1 à 150 nm.

17. Dispositif électroluminescent organique selon une ou plusieurs des revendications 1 à 16, **caractérisé en ce que** les couches de transport d'électrons et de blocage de trous présentent une épaisseur de 1 à 150 nm.

18. Dispositif électroluminescent organique selon une ou plusieurs des revendications 1 à 17, **caractérisé en ce que** les couches de transport d'électrons et de blocage de trous et d'émetteur présentent chacune une épaisseur différente dans la plage de 1 à 150 nm.

19. Dispositif électroluminescent organique selon une ou plusieurs des revendications 1 à 18, **caractérisé en ce que** la température de transition vitreuse T_{g} de l'émetteur est supérieure à 90°C.

20. Dispositif électroluminescent organique selon une ou plusieurs des revendications 1 à 19, **caractérisé en ce que** la température de transition vitreuse T_{g} des matériaux de matrice des couches d'émission est supérieure à 100°C.

21. Dispositif électroluminescent organique selon une ou plusieurs des revendications 1 à 20, **caractérisé en ce que** la température de transition vitreuse T_{g} de tous les matériaux qui sont utilisés dans toutes les couches est supérieure à 90°C.
